# EUROPEAN PATENT SPECIFICATION

(11) **EP 2 422 383 B1**
(45) Date of publication and mention of the grant of the patent: **30.11.2016**
(21) Application number: 10718308.9
(22) Date of filing: 23.04.2010
(51) Int. Cl.: H01L 51/00, H01L 51/52

(54) **OPTOELECTRIC DEVICE AND METHOD FOR MANUFACTURING THE SAME**
OPTOELEKTRISCHE EINRICHTUNG UND VERFAHREN ZU IHRER HERSTELLUNG
DISPOSITIF OPTO-ÉLECTRIQUE ET SON PROCÉDÉ DE FABRICATION

(30) Priority: 23.04.2009 EP 09158618
(43) Date of publication of application: 29.02.2012
(73) Proprietor: Nederlandse Organisatie voor toegepast- natuurwetenschappelijk onderzoek TNO, 2595 DA 's-Gravenhage (NL); OLEDWorks GmbH, 52068 Aachen (DE)
(72) Inventor: LIFKA, Herbert, NL-5691 LP Son en Breugel (NL); VAN DE WEIJER, Peter, NL-5591 PW Heeze (NL); VAN MOL, Antonius Maria Bernardus, NL-5658 HC Eindhoven (NL)
(74) Representative: V.O.
(86) International application number: PCT/NL2010/050221
(87) International publication number: WO 2010/123362

(56) References cited:
- EP-A1- 1 983 079
- WO-A-2007/036850
- WO-A2-2008/061524
- GB-A- 2 437 112
- US-A1- 2005 237 279
- US-A1- 2005 258 436
- US-A1- 2007 132 371
- US-A1- 2009 079 345

## Description

### BACKGROUND OF THE INVENTION

### Field of the invention

The present invention relates to a method for manufacturing an optoelectric device. The present invention further relates to an optoelectric device.

### Related Art

Optoelectric devices are devices that source, detect or control light. Examples are LEDs, photovoltaic cells, and electrochromic devices. These devices require electrical conducting layers, at least one of which is transparent, so that light generated by the optoelectric active layer of the device can be emitted to the environment or light from the environment can reach the optoelectric active layer. For large area LEDs, such as large area OLED lighting on flexible plastic substrates, a large current is required to drive the system. The present thin film materials used for the anode (e.g. ITO) and cathode (e.g. Ba/Al) have a large resistivity and the large currents give rise to substantial voltage drop, which on its turn causes an inhomogeneous light emission. For producing large area flexible OLED devices on plastic substrates there is a need for an additional metallization structure of the plastic substrate. For reducing the manufacturing costs, such structured metallization coatings will preferably be applied on rolls of plastic foil using an inline roll-to-roll web coating process. Accordingly, for (O)LEDs but also for other optoelectric devices, such as electro-chromic devices, and photo-voltaic products there is a need for a metallization structure that on the one hand has a good electrical conductivity, while on the other hand has a high transmission for radiation. According to state-of-the-art roll-to-roll web coating techniques, a system for full metallization or patterned metallization areas of a continuous substrate has been reported.

A known method for applying a metallization structure is to apply the metal lines with evaporation, while defining the structure with a shadowmask. This method is cumbersome and slow as in practice after applying a few hundred nm of the metallization structure the shadow mask has to be cleaned, while a thickness of several µm, e.g. 5 to 20 µm is desired. In order to still achieve a sufficient conduction the metallization structure has to be applied with relatively large linewidths, which is unfavorable when shunting transparent electrodes. Furthermore, the shadowmask requires a 3D construction in order to make it possible that both the shadow mask is a single connected structure and the metal shunting applied therewith is a single connected structure.

WO2008/061524 A2 relates to lighting elements and methods for the production thereof in order to make available particularly large-area lighting elements based on organic light emitting diodes that homogeneously emit electromagnetic radiation across the entire possible area. This is achieved by covering the organic light emitting diodes with an electrically insulating intermediate layer on which an electrically conducting metal layer is arranged that forms an electrically conducting connection to the base electrode along with contact elements penetrating the intermediate layer. WO2008/061524 A2 suggests to apply the metal layer by a vapor deposition process or by a galvanic process.

US2005258436 also discloses a lighting device having a large area wherein luminance nonuniformity is suppressed. Therein a layer including a light emitting material is formed between a first electrode and a second electrode, and a third electrode is formed to connect to the first electrode through an opening formed in the second electrode and the layer including a light emitting material.

Another known method is described in WO2007/036850. According to the method described therein a barrier layer structure having first openings is formed over a first face of a structure comprising an electroactive material between a first electrode and a second electrode. As the barrier layer structure can have a relatively modest thickness it can be efficiently deposited with evaporation. Subsequently a plating base is deposited upon the barrier layer structure. The plating base contacts contact areas of the electrodes. A patterned insulator having second openings is applied upon said barrier layer structure with the plating base so that the second openings are aligned with the first openings. Within the openings a metal conductor is electroplated that contacts the plating base. During electroplating the structure
with the barrier layer structure, the plating base and the resist layer is lowered into an electroplating bath containing suitable ions such as Cu ions. The barrier layer structure and the plating base efficiently prevent any contact between the liquid, mainly water, of the electroplating bath and the structure. This is necessary as the material used for the cathode may be corroded by the liquid. Even if the electrode itself is not corroded it does not provide sufficient protection to the underlying organic materials. By the process of electroplating within the structure defined by the patterned insulator, an electrically conductive shunting structure is obtained that can have a relatively large height in comparison to their width. In this way the electrically conductive structure has a good conductivity, while having a good overall transparency for light.

It is observed in WO2007/036850, that electroplating of the metal conductors could be made also in the absence of a plating base. However, in such case the electroplating process would become very slow due to the high resistivity of the anode layer and the cathode layer. WO2007/036850 further observes that it is also possible to design a light emitting device, which has only one metal conductor, which is connected to either the anode layer or the cathode layer. In practice this is however not possible with the technology disclosed in WO2007/036850. In practice the plating base does not provide sufficient protection against corrosion of the interface between the electrode and the underlying organic materials by the liquid. Neither can the transparent electrode provide for protection, as this electrode has to be relatively thin to allow a sufficient transmission of light. Accordingly in the design of WO2007/036850 the organic layer has to be interrupted where the shunting structure contacts the transparent electrode. Accordingly also the opposite electrode should be interrupted to prevent a short circuit between the electrodes. As the opposite electrode is interrupted it requires a second shunting structure which on its turn interrupts the transparent electrode structure. The two shunting structures need to be formed as a first and a second grid that are entangled in each other, but that are mutually electrically insulated, as shown in FIG. 1 of WO2007/036850, or in the form of mutually complementary combs. Accordingly these structures have a high initial resistance between the edges of the structures and locations remote therefrom. This necessitates a plating base to allow for a sufficiently rapid electroplating process.

There is a need to efficiently manufacture an optoelectric device with a reduced number of steps.

### SUMMARY OF THE INVENTION

According to an aspect of the present invention an electroplating method is provided as claimed in claim 1.

According to another aspect of the present invention an optoelectric device is provided as claimed in claim 11.

As an ionic liquid is used as the electrolyte, a solvent, such as water, is not necessary. Therewith it is not necessary that the structure comprising the optoelectric material is protected against the solvent. Accordingly the required metal for the shunting structure may be deposited directly from the ionic liquid at the electrode. Therewith intermediate steps like applying a plating base are obviated. Moreover, the direct contact between the shunting structure and the electrode is favorable for electrical conduction. Although the deposition process may initially be relatively slow it rapidly accelerates once a small amount of metal is deposited at the electrode. It is an additional advantage that in this way materials, such as aluminum, may be deposited that could not be deposited from aqueous solutions. Although the method according to the present invention is particularly useful where the optoelectric material is an organic material, alternatively an inorganic material may be applied as the optoelectric material.

It is noted that EP1983592 discloses a method for manufacturing an (electrode for an) organic electronic device, comprising providing an electrode to a surface of an electro-active material - the electro-active material comprising an organic electro-active compound - by electro-deposition, using a plating liquid comprising an ionic liquid and metal or metalloid ions which metal or metalloid ions are reduced and deposited to form an electrode. EP1983592 does not disclose the use of a shunting structure in the form of a grid.

In the method according to the present invention the use of an ionic liquid as the electrolyte makes it possible that the organic (active) layer(s) are continuous, as there can be no corrosion of the interface between the transparent electrode and said organic layer(s) by the liquid. Therewith also the non-transparent electrode can be continuous, so that it does not require a separate shunting structure. Accordingly a single shunting structure can be used for the transparent electrode and the transparent electrode can be continuous. Accordingly, even if the electrode itself is not sufficiently conductive to provide for a homogeneous light-emission in an OLED, it does have a sufficient conduction to serve itself as the plating base for the deposition of the metal shunting layer from the ionic liquid.

Additional layers may be present between the cathode and the shunting structure. In an embodiment, for example, the cathode is covered by a layer of a wide bandgap semiconductor. Calcium is preferred as a metal for the cathode because of its relatively high optical transmissivity for a metal and because of its proven ability to form a good electron injecting contact to materials. ZnSe, ZnS or an alloy of these materials are the preferred semiconductors because of their good conductivity parallel to the direction of light emission, their ability to protect the underlying low work function metal and organic films and their transparency to the emitted light.

In addition to providing the at least one electrode with a shunting structure in this way, also the other electrode may be provided with a shunting structure. It is not necessary that the method described above is used for applying the shunting structure for the other electrode in case said other electrode is provided before the at least one layer of optoelectric active material is applied. In that case the other electrode may be applied by conventional electroplating, for example by electroplating a layer of silver or copper.

In an embodiment the patterned electrically insulating layer structure is defined by a shadow mask. The electrically insulating layer structure can be relatively thin (e.g. 100 a 200 nm) so that it can be efficiently deposited by a CVD process. The required shadow mask can be a 2D connected structure.

In an embodiment the electrically insulating layer structure is applied by printing. As the metallic layer in the openings of the electrically insulating layer is formed by an ionic liquid, it is not necessary that the electrically insulating layer also has a barrier function. This makes it possible to use a printing technique, such as screen printing, inkjet printing, jet-printing, gravure printing, offset printing.

In an embodiment the patterned electrically insulating layer structure is a barrier layer structure. This has the advantage that the electrically insulating layer structure serves a double function. During manufacturing it serves to define the shape of the metallic layer that is applied from the ionic liquid and in the finished product it protects the optoelectric active material. To provide for a good barrier function the patterned electrically insulating layer structure forming the barrier layer structure may comprise a sequence of layers, in particular a sequence of inorganic layers or inorganic layers separated by organic layers.

In another embodiment a barrier layer structure is applied on top of the metallic layer. In that embodiment it is not necessary that the patterned electrically insulating layer structure is a barrier layer structure. Likewise a barrier layer structure on top of the metallic layer may comprise a sequence of layers, in particular a sequence of inorganic layers or inorganic layers separated by organic layers.

In a further embodiment a further layer of an optoelectric active material sandwiched between a first further electrode and a second further electrode is provided wherein the first further electrode is applied at the patterned electrically insulating layer structure with the metallic layer. In this way a series connection of OLEDs may be realized.

In a first variant of said embodiment both the layer of an optoelectric active material and the further layer of an optoelectric active material are a light-emitting layer. In this way two light emitting devices are arranged in series, therewith enabling a doubling of the light-output with the same supply current. If desired more light emitting devices may be stacked in this way.

Also hybrid optoelectric devices may be constructed in this way. In a second variant of the embodiment having a further layer of an optoelectric active material, the layer of an optoelectric active material is a light-emitting layer and the further layer of an optoelectric active material is a photo-voltaic layer. In a third variant the layer of an optoelectric active material is a light-emitting layer and the further layer of an optoelectric active material is an electrochromic layer.

The second and the third variant are particularly suitable in a window pane or a signage device. The second variant can be used at day-time in a first mode as an energy source that converts a part of the incoming light in electric energy, therewith at the same time tempering the intensity of the incoming light. At night-time the pane can be used in a second mode as a light source. The light emitting layer may be patterned, e.g. in a window pane used as a signage device. The metallic layer is efficiently used as it serves as common electric supply conductor. In the first mode it serves as a power supply line from the photo-voltaic layer to outside the pane. In the second mode it serves as a power supply line towards the light-emitting layer

In said third variant the electrochromic layer allows for a more controllable tempering of the incoming light. The combination of electrochromic layer and the light-emitting layer make it possible provide a window pane that provides for a controllable amount of light, e.g. to supply a constant intensity regardless the time of the day. Also in this variant the metallic layer serves as common electric supply conductor, in this case for the light-emitting layer and for the electrochromic layer.

In embodiments of the opto-electric device the metallic structure may comprise traces of the ionic liquid used for electrodeposition.

### BRIEF DESCRIPTION OF THE DRAWINGS

These and other aspects are described in more detail with reference to the drawing. Therein:
Figure 1 shows a basic structure of an optoelectric device,
Figure 2 shows a semifinished product obtained by a conventional method,
Figure 3 schematically shows an embodiment of a method according to the present invention,
Figure 4 shows a semifinished product obtained with the first and the second step of this method,
Figure 5 shows in more detail the third step of the method shown in Figure 3,
Figure 6 shows the semifinished product obtained with this third step,
Figure 7 shows a top-view of the metallic layer obtained with this third step according to VII in Figure 6,
Figure 7A shows a detail of the metallic layer according to 7A in Figure 7,
Figure 7B shows a corresponding detail of a metallic layer obtained in another embodiment of the method,
Figure 8 shows the product obtained after a fourth step of the method is applied,
Figure 9 shows two optoelectric devices stacked upon each other, at least one of which is obtained by the method according to Figure 3.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.
Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.. In case of conflict, the present specification, including definitions, will control. In addition, the materials, methods, and examples are illustrative only and not intended to be limiting.

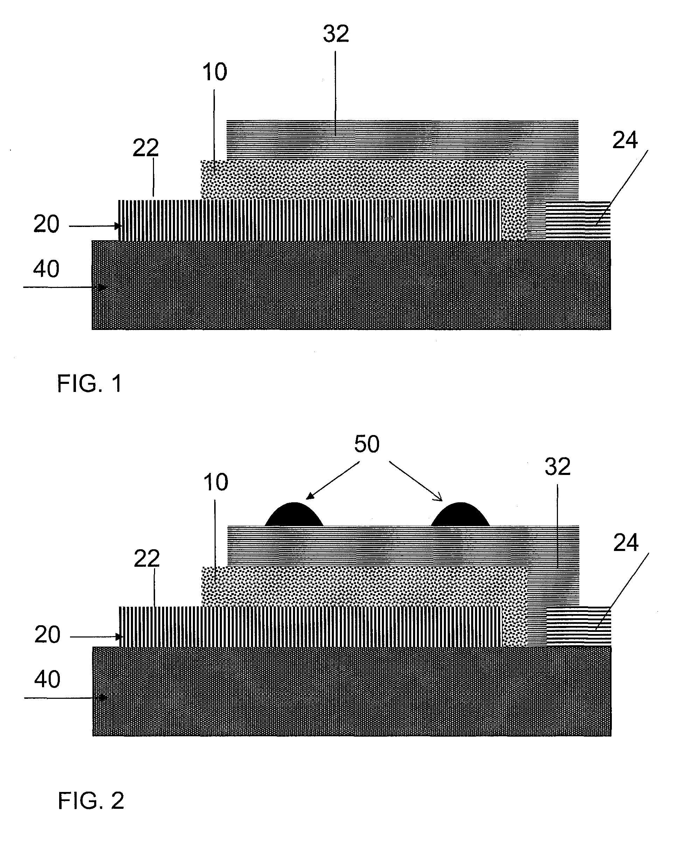

Figure 1 shows a basic structure of an optoelectric device. The device comprises a layer of an optoelectric active material 10 that is sandwiched between a first electrode 22 and a second electrode 32. The first electrode 22 is formed by a first portion of an electrically conductive layer 20 that is applied at a substrate 40. The electrically conductive layer comprises a second portion 24 that is electrically insulated from the first portion 22. The second electrode 32 extends over this second portion 24 of the electrically conductive layer 20.

Figure 2 shows schematically shows a result of a known method, wherein a metallization structure 50 is applied by vapor deposition through a shadow mask. This known method is not attractive as it can in practice only be used to deposit a layer of a few hundred nm of the metal, while a layer in the order of a few µm or more is desired.

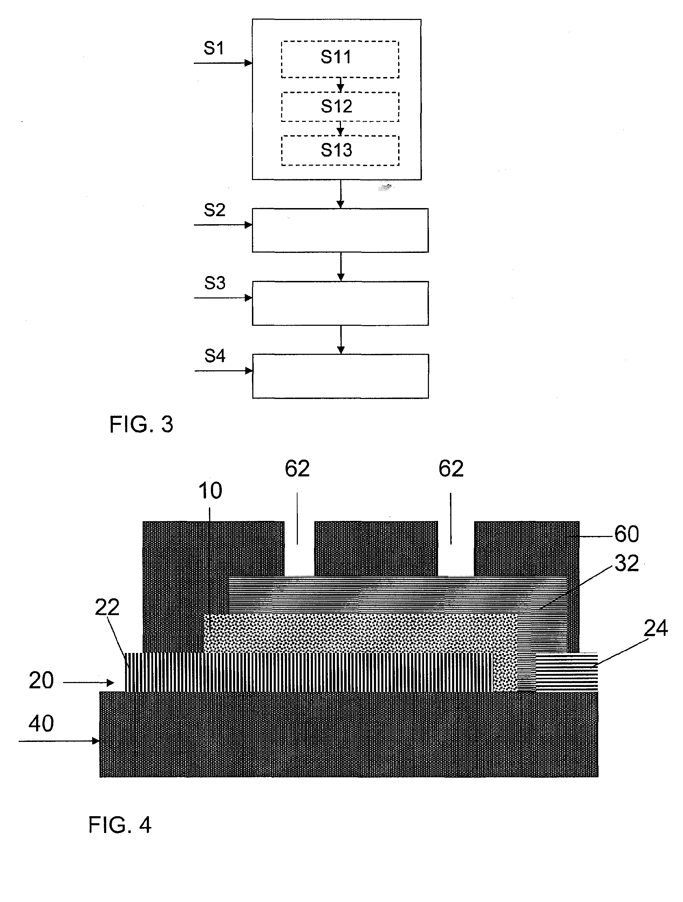

An embodiment of a method according to the present invention is schematically illustrated in Figure 3. The embodiment of the method illustrated therein comprises a first step S1 wherein a layer of an optoelectric active material is applied between a first electrode and a second electrode. This first electrode is usually the anode, as it can have a high work-function. This facilitates further processing steps. In some processes the cathode may be applied as the first electrode, for example in processes using doped small molecule OLED materials. The first step S1 comprises a first substep S11 of providing the first electrode e.g. at a substrate a second substep S12 of providing the layer of optoelectric active material and the third substep S13 of providing the second electrode. The first electrode, e.g. the anode, may be applied for example by wet chemical electro deposition, sputtering, printing methods etc. The optoelectric active material, or a stack of materials may be applied by printing techniques for example. Vapor deposition, e.g. physical vapor deposition is the preferred way to apply the cathode. The embodiment shown in Figure 3 further comprises a second step S2. The result of the first and the second step is shown in Figure 4. In the second step S2 a patterned electrically insulating layer structure 60 is applied at at least one of said electrodes 32, here the cathode. It is not necessary that the patterned electrically insulating layer structure 60 is applied directly upon said electrode. One or more intermediate layers may be applied at the at least one of said electrode. In this case for example a semiconducting layer may be applied at the cathode 32 before applying the patterned electrically insulating layer structure. The patterned electrically insulating layer structure 60 that is deposited has openings 62 that leave free portions of the at least one of the electrodes, here the second electrode 32. Various options are possible to deposit the patterned electrically insulating layer structure 60, e.g. the layer may be applied as a continuous layer which is subsequently patterned, e.g. by etching or by imprinting. Alternatively the layer may be directly applied in its patterned form, e.g. by printing. Most preferably the layer is applied by evaporation, e.g. by a CVD process, such as thermal chemical vapour deposition (CVD), photo assisted chemical vapour deposition (PACVD), plasma enhanced chemical vapour deposition (PECVD), etc and patterned using a mask.

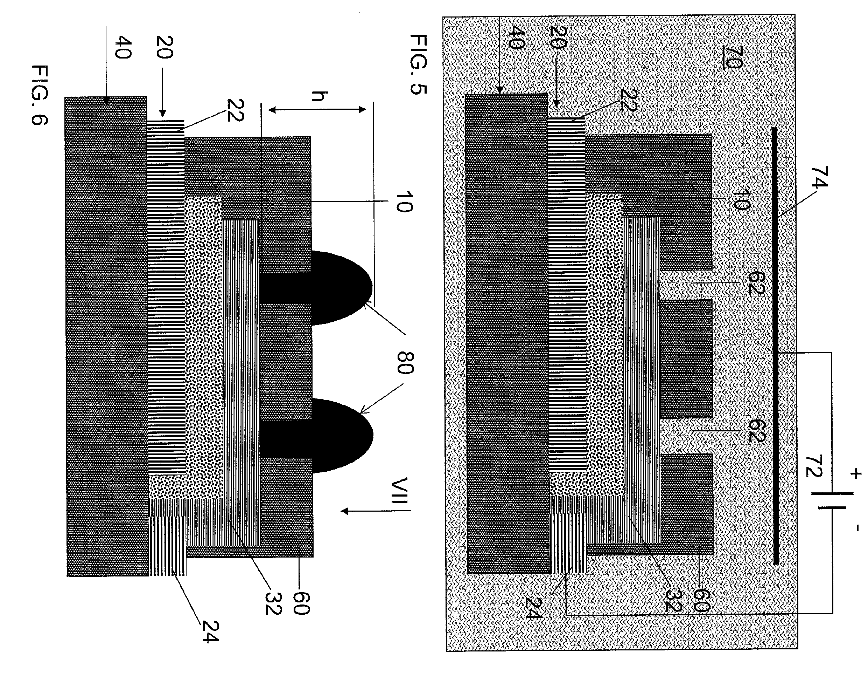

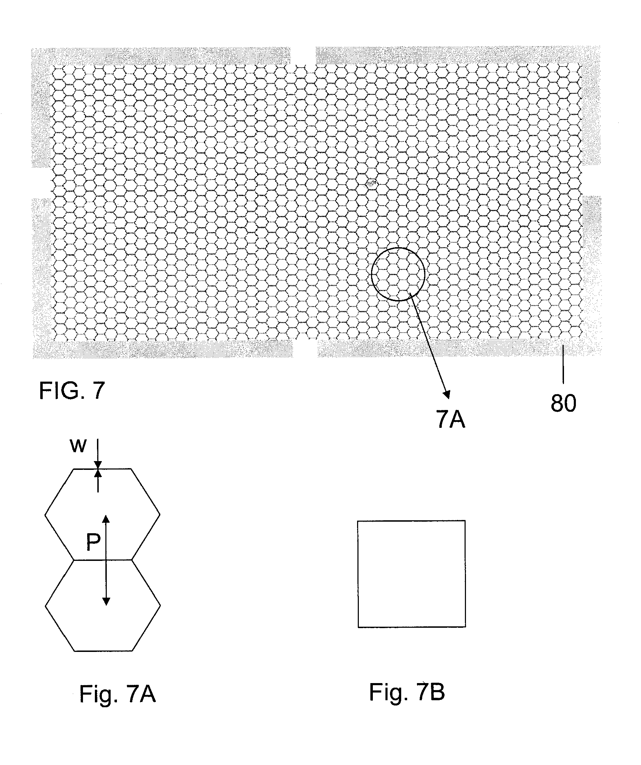

The embodiment further comprises a third step S3. This execution of this step S3 is shown in detail in Figure 5, while its result is shown in Figure 6. As shown in Figure 5 the intermediate product shown in Figure 4 is submerged in a bath comprising an ionic liquid 70. Therewith the electrolyte 70 is provided in the openings 62 of the patterned electrically insulating layer structure 60. In step S4 a metallic layer 80 is deposited at the free portions of the second electrode 32 by electroplating from an ionic liquid 70. To that end the electrode 32 to be provided with the metallic deposition is coupled to a negative pole of a battery 72. The positive pole of a battery is coupled to an auxiliary electrode 74. Instead of submerging the semifinished product in a bath with an ionic liquid, the ionic liquid may be rolled out over the surface and brought into contact with the auxiliary electrode 74. After carrying out step S4 the metallic layer 80 that is deposited at the free portions of the second electrode 32 forms a metal structure 80. This is schematically illustrated in Figure 7 according to top-view VII in Figure 6. Figure 7A shows a detail of this structure according to 7A in Figure 7. In the embodiment shown the metal structure 80 is deposited directly at the free portions of the second electrode 32 (shown in fig. 6). The metal deposition process may continue until the metal structure 80 has a height h in the order of a few µm to a few tens of µm, e.g. about 10 µm. Although the metal structure also grows in the lateral direction, the lateral dimensions remain small enough to be substantially invisible. For example the patterned electrically insulating layer structure 60 (shown in fig. 6) may have grooves having a width in the order of 50 to 100 µm that are mutually spaced at a distance of a few mm. Taking into account that the metal structure grows substantially isotropically, the structure will have a width w in the range of 70 to 120 µm in this example and a pitch P of a few mm, e.g. 3 mm as is shown schematically in Figure 7A. The metal structure 80 herewith is substantially invisible to the human eye and will only absorb a minor fraction of radiation generated by the optoelectric device in case of an OLED or of in case of an photovoltaic device, radiation impingent from the environment. Instead of a hexagonal structure as shown in Figures 7, 7A, also other structures may be used, e.g. the rectangular structure of Figure 7B.

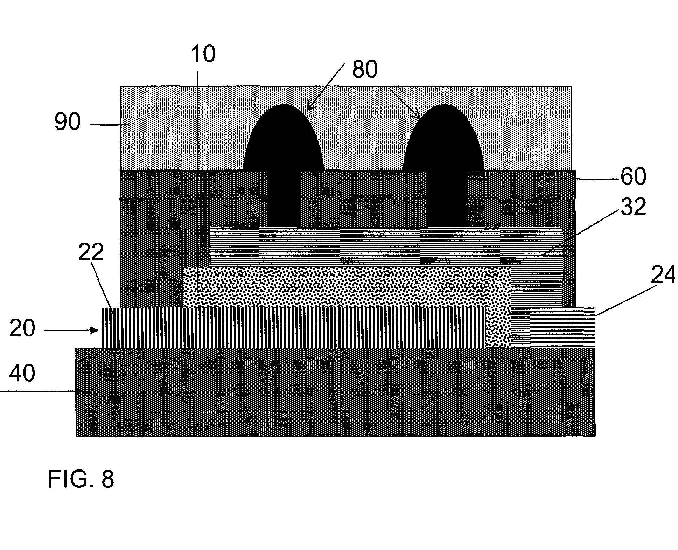

Step S3 may be followed by a further step S5, wherein a barrier layer structure 90 is applied on top of the metallic layer. Therewith the result shown in Figure 8 is obtained. The barrier layer structure 90 may comprise a sequence of inorganic layers, such as the sequence SiN,SiO,SiN,SiO,SiN, also denoted as NONON. Alternatively, the structure may comprise a sequence of alternating organic and inorganic layers, e.g. an organic layer that is sandwiched between a first and a second inorganic layer. The patterned electrically insulating layer structure may also comprise such sequence of inorganic layers or inorganic layers and organic layers. The barrier layer structure 90 may be applied in addition to a barrier layer structure formed by the electrically insulating layer structure 60. Alternatively, when a barrier layer structure 90 is applied the electrically insulating layer structure 60 does not need to have a barrier function. In that case for example a single layer of an organic material may be used for the electrically insulating layer structure 60.

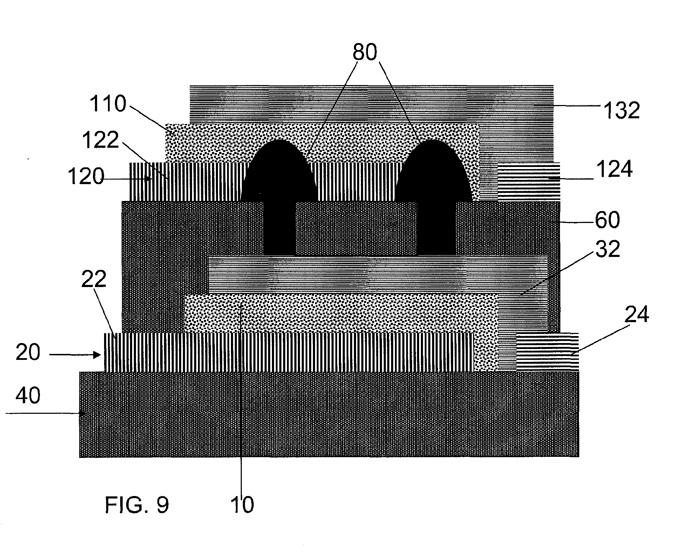

As shown in Figure 9, the metal structure 80 may be used as a contact to a further optoelectric device that is applied upon the optoelectric device formed by steps S1-S3 as shown in Figure 6. In accordance therewith, in a step S5 a further layer of an optoelectric active material 110 is sandwiched between a first further electrode 122, which is formed by a further electrically conductive layer 120, and a second further electrode 132. This second further electrode 132 is electrically connected to a portion 124 of the further electrically conductive layer 120. The optoelectric active material may be an organic or an inorganic material. Organic materials have the advantage that they can be processed at a low temperature. The first further electrode 122 is applied at the patterned electrically insulating layer structure 60 with the metallic layer 80. After completion of step S5, steps S2 and S3 may be repeated so that also the further optoelectric device has a shunt structure. As might be clear the process described in fig 9 can be repeated several times and also several different electro-optical devices can stacked on top of each other.

The following combinations of a layer 10 of an opto-electric active material and a further layer of an opto-electric active material 110 are particularly useful.

In a first variant both the layer 10 of an organic optoelectric active material and the further layer 110 of an optoelectric active material are a light-emitting layer. In this way two light emitting devices are arranged in series, therewith enabling a doubling of the light-output with the same supply current. If desired more light emitting devices may be stacked in this way.
Also hybrid optoelectric devices may be constructed in this way. In a second variant the layer 10 is a light-emitting layer and the further layer 110 is a photo-voltaic layer. In a third variant the layer 10 is a light-emitting layer and the further layer 110 is an electrochromic layer.
The second and the third variant are particularly suitable in a window pane or a signage device. The second variant can be used at day-time in a first mode as an energy source that converts a part of the incoming light in electric energy, therewith at the same time tempering the intensity of the incoming light. At night-time the pane can be used in a second mode as a light source. The light emitting layer 10 may be patterned, e.g. in a window pane used as a signage device. The metallic layer 120 is efficiently used as it serves as common electric supply conductor. In the first mode it serves as a power supply line from the photo-voltaic layer 110 to outside the pane. In the second mode it serves as a power supply line towards the light-emitting layer 10. In the third variant the electrochromic layer 110 allows for a more controllable tempering of the incoming light, as compared to a photo-voltaic layer. The combination of electrochromic layer 110 and the light-emitting layer 10 make it possible provide a window pane that provides for a controllable amount of light, e.g. to supply a constant intensity regardless the time of the day. Also in this variant the metallic layer 120 serves as common electric supply conductor, in this case for the light-emitting layer 10 and for the electrochromic layer 110.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. Method for manufacturing an optoelectric device comprising the steps of
- providing (S1) a layer (10) of an optoelectric active material between a first electrode (22) and a second electrode (32), wherein the first electrode (22) is formed by a first portion of an electrically conductive layer (20) that is applied at a substrate (40), wherein the electrically conductive layer comprises a second portion (24),
- providing (S2) a patterned electrically insulating layer structure (60) on said second electrode (32), the patterned electrically insulating layer structure having openings (62),
- providing (S3) an electrolyte (70) in said openings,
- depositing (S4) a metallic layer (80) in said openings from the electrolyte by electroplating, therewith coupling a negative electric pole (-) to the second electrode (32) and coupling an associated positive electric pole (+) to an auxiliary electrode (74) in contact with the electrolyte,
**characterized in that** the electrolyte is formed by an ionic liquid, and **in that** the second portion (24) of the electrically conductive layer (20) is electrically insulated from the first portion (22), wherein the second electrode (32) extends over this second portion (24) of the electrically conductive layer (20), wherein in said depositing step (S4) the second electrode (32) is coupled to the negative pole (-) via the second portion (24) of the electrically conductive layer (20).

2. Method according to claim 1, wherein the patterned electrically insulating layer structure (60) is a barrier layer structure.

3. Method according to claim 1 or 2, **characterized in that** the patterned electrically insulating layer structure (60) is defined by a shadow mask.

4. Method according to claim 1, wherein the patterned electrically insulating layer structure (60) is defined with a printing technique.

5. Method according to claim 1, wherein a barrier layer structure (90) is applied on top of the metallic layer.

6. Method according to claim 2, wherein a further barrier layer structure (90) is applied on top of the metallic layer.

7. Method according to claim 1, wherein a further layer (110) of an optoelectric active material sandwiched between a first further electrode (122) and a second further electrode (132) is provided wherein the first further electrode is applied on the patterned electrically insulating layer structure provided with the metallic layer.

8. Method according to claim 7, wherein both the layer (10) of an optoelectric active material and the further layer (110) of an optoelectric active material is a light-emitting layer.

9. Method according to claim 7, wherein the layer (10) of an optoelectric active material is a light-emitting layer and the further layer (110) of an optoelectric active material is a photo-voltaic layer.

10. Method according to claim 7, wherein the layer (10) of an optoelectric active material is a light-emitting layer and the further layer (110) of an optoelectric active material is an electrochromic layer.

11. Optoelectric device comprising
- a layer (10) of an optoelectric active material between a first electrode (22) and a second electrode (32), wherein, the first electrode (22) is formed by a first portion of an electrically conductive layer (20) that is applied at a substrate (40), wherein the electrically conductive layer comprises a second portion (24),
- a patterned electrically insulating layer structure (60) on said second electrode (32), the patterned electrically insulating layer structure having openings (62)
- a metallic structure (80) on the patterned electrically insulating layer structure (60) that extends through the openings (62) of the patterned electrically insulating layer to the second electrode (32), therewith directly contacting the second electrode (32),
wherein the second portion (24) of the electrically conductive layer (20) is electrically insulated from the first portion (22), wherein the second electrode (32) extends over this second portion (24) of the electrically conductive layer (20), **characterized in that** the second electrode (32) is electrically connected with the second portion (24) of the electrically conductive layer (20).

12. Optoelectric device according to claim 11, comprising a stack with a further layer (110) of an optoelectric active material between a third electrode (122) and a fourth electrode (132), said stack (110, 132, 122) being arranged on the patterned electrically insulating layer structure (60) provided with the metallic structure (80).

13. Optoelectric device according to claim 12, wherein both the layer (10) of an optoelectric active material and the further layer (110) of an optoelectric active material is a light-emitting layer.

14. Optoelectric device according to claim 12, wherein the layer (10) of an optoelectric active material is a light-emitting layer and the further layer (110) of an optoelectric active material is a photo-voltaic layer.

15. Optoelectric device according to claim 12, wherein the layer (10) of an optoelectric active material is a light-emitting layer and the further layer (110) of an optoelectric active material is an electrochromic layer.

## Patentansprüche

1. Verfahren zur Herstellung einer optoelektrischen Einrichtung, umfassend folgende Schritte:
- Bereitstellung (S1) einer Schicht (10) eines optoelektrisch aktiven Materials zwischen einer ersten Elektrode (22) und einer zweiten Elektrode (32), wobei die erste Elektrode (22) von einem ersten Abschnitt einer elektrisch leitenden Schicht (20), angewendet auf ein Substrat (40), gebildet wird, wobei die elektrisch leitende Schicht einen zweiten Abschnitt (24) umfasst,
- Bereitstellung (S2) einer gemusterten elektrisch isolierenden Schichtstruktur (60) auf der zweiten Elektrode (32), welche gemusterte elektrisch isolierende Schichtstruktur Öffnungen (62) aufweist,
- Bereitstellung (S3) eines Elektrolyten (70) in den Öffnungen,
- Abscheidung (S4) einer metallischen Schicht (80) in den Öffnungen von dem Elektrolyten durch Galvanisieren, um einen negativen elektrischen Pol (-) mit der zweiten Elektrode (32) zu koppeln und einen zugehörigen positiven elektrischen Pol (+) mit einer Hilfselektrode (74), die in Kontakt mit dem Elektrolyten ist, zu koppeln,
**dadurch gekennzeichnet, dass** der Elektrolyt von einer ionischen Flüssigkeit gebildet wird und dass der zweite Abschnitt (24) der elektrisch leitenden Schicht (20) elektrisch von dem ersten Abschnitt (22) isoliert ist, wobei die zweite Elektrode (32) über diesen zweiten Abschnitt (24) der elektrisch leitenden Schicht (20) verläuft, wobei in dem Abscheidungsschritt (S4) die zweite Elektrode (32) über den zweiten Abschnitt (24) der elektrisch leitenden Schicht (20) an den negativen Pol (-) gekoppelt wird.

2. Verfahren nach Anspruch 1, wobei die gemusterte elektrisch isolierende Schichtstruktur (60) eine Barrierenschichtstruktur ist.

3. Verfahren nach Anspruch 1 oder 2, **dadurch gekennzeichnet, dass** die gemusterte elektrisch isolierende Schichtstruktur (60) durch eine Lochmaske definiert wird.

4. Verfahren nach Anspruch 1, wobei die gemusterte elektrisch isolierende Schichtstruktur (60) mit einer Drucktechnik definiert wird.

5. Verfahren nach Anspruch 1, wobei eine Barrierenschichtstruktur (90) über der metallischen Schicht aufgebracht wird.

6. Verfahren nach Anspruch 2, wobei eine weitere Barrierenschichtstruktur (90) über der metallischen Schicht aufgebracht wird.

7. Verfahren nach Anspruch 1, wobei eine weitere Schicht (110) eines optoelektrisch aktiven Materials, eingeschoben zwischen eine erste weitere Elektrode (122) und eine zweite weitere Elektrode (132) bereitgestellt ist, wobei die erste weitere Elektrode auf die mit der metallischen Schicht bereitgestellte gemusterte elektrisch isolierende Schichtstruktur aufgebracht wird.

8. Verfahren nach Anspruch 7, wobei sowohl die Schicht (10) eines optoelektrisch aktiven Materials als auch die weitere Schicht (110) eines optoelektrisch aktiven Materials eine lichtemittierende Schicht ist.

9. Verfahren nach Anspruch 7, wobei die Schicht (10) eines optoelektrisch aktiven Materials eine lichtemittierende Schicht ist und die weitere Schicht (110) eines optoelektrisch aktiven Materials eine fotovoltaische Schicht ist.

10. Verfahren nach Anspruch 7, wobei die Schicht (10) eines optoelektrisch aktiven Materials eine lichtemittierende Schicht ist und die weitere Schicht (110) eines optoelektrisch aktiven Materials eine elektrochrome Schicht ist.

11. Optoelektrische Einrichtung, umfassend
- eine Schicht (10) eines optoelektrisch aktiven Materials zwischen einer ersten Elektrode (22) und einer zweiten Elektrode (32), wobei die erste Elektrode (22) von einem ersten Abschnitt einer elektrisch leitenden Schicht (20) gebildet wird, die auf ein Substrat (40) angewendet wird, wobei die elektrisch leitende Schicht einen zweiten Abschnitt (24) umfasst,
- eine gemusterte elektrisch isolierende Schichtstruktur (60) auf der zweiten Elektrode (32), welche gemusterte elektrisch isolierende Schicht Öffnungen (62) aufweist,
- eine metallische Struktur (80) auf der gemusterten elektrisch isolierenden Schichtstruktur (60), die durch die Öffnungen (62) der gemusterten elektrisch isolierenden Schicht zu der zweiten Elektrode (32) verläuft, womit die zweite Elektrode (32) direkt kontaktiert wird,
wobei der zweite Abschnitt (24) der elektrisch leitenden Schicht (20) elektrisch von dem ersten Abschnitt (22) isoliert ist, wobei die zweite Elektrode (32) über diesen zweiten Abschnitt (24) der elektrisch leitenden Schicht (20) verläuft, **dadurch gekennzeichnet, dass** die zweite Elektrode (32) elektrisch mit dem zweiten Abschnitt (24) der elektrisch leitenden Schicht (20) verbunden ist.

12. Optoelektrische Einrichtung nach Anspruch 11, umfassend einen Stapel mit einer weiteren Schicht (110) eines optoelektrisch aktiven Materials zwischen einer dritten Elektrode (122) und einer vierten Elektrode (132), welcher Stapel (110, 132, 122) auf der mit der metallischen Struktur bereitgestellten gemusterten elektrisch isolierenden Schichtstruktur (60) angeordnet ist.

13. Optoelektrische Einrichtung nach Anspruch 12, wobei sowohl die Schicht (10) eines optoelektrisch aktiven Materials als auch die weitere Schicht (110) eines optoelektrisch aktiven Materials eine lichtemittierende Schicht ist.

14. Optoelektrische Einrichtung nach Anspruch 12, wobei die Schicht (10) eines optoelektrisch aktiven Materials eine lichtemittierende Schicht ist und die weitere Schicht (110) eines optoelektrisch aktiven Materials eine fotovoltaische Schicht ist.

15. Optoelektrische Einrichtung nach Anspruch 12, wobei die Schicht (10) eines optoelektrisch aktiven Materials eine lichtemittierende Schicht ist und die weitere Schicht (110) eines optoelektrisch aktiven Materials eine elektrochrome Schicht ist.

## Revendications

1. Méthode de fabrication d'un dispositif opto-électrique comprenant les étapes consistant à :
- fournir (S1) une couche (10) d'un matériau opto-électrique actif entre une première électrode (22) et une seconde électrode (32), dans laquelle la première électrode (22) est formée par une première partie d'une couche électriquement conductrice (20) qui est appliquée au niveau d'un substrat (40), dans laquelle la couche électriquement conductrice comprend une seconde partie (24),
- agencer (S2) une structure de couche électriquement isolante munie d'un motif (60) sur ladite seconde électrode (32), la structure de couche électriquement isolante munie d'un motif ayant des ouvertures (62),
- agencer (S3) un électrolyte (70) dans les ouvertures,
- déposer (S4) une couche métallique (80) dans lesdites ouvertures à partir de l'électrolyte par électro placage, afin de relier un pôle électrique négatif (-) à la seconde électrode (32) et relier un pôle électrique positif associé (+) à une électrode auxiliaire (74) en contact avec l'électrolyte,
**caractérisée en ce que** l'électrolyte est formé par un liquide ionique, et **en ce que** la seconde partie (24) de la couche électriquement conductrice (20) est électriquement isolée de la première partie (22), la seconde électrode (32) s'étendant sur cette seconde partie (24) de la couche électriquement conductrice (20), dans laquelle dans ladite étape de dépôt (S4) la seconde électrode (32) est reliée au pôle négatif (-) par l'intermédiaire de la seconde partie (24) de la couche électriquement conductrice (20).

2. Méthode selon la revendication 1, dans laquelle la structure de couche électriquement isolante munie d'un motif (60) est une structure de couche barrière.

3. Méthode selon la revendication 1 ou 2, **caractérisée en ce que** la structure de couche électriquement isolante munie d'un motif (60) est définie par un masque perforé.

4. Méthode selon la revendication 1, dans laquelle la structure de couche électriquement isolante munie d'un motif (60) est définie à l'aide d'une technique d'impression.

5. Méthode selon la revendication 1, dans laquelle une structure de couche barrière (90) est appliquée sur la partie supérieure de la couche métallique.

6. Méthode selon la revendication 2, dans laquelle une structure de couche barrière supplémentaire (90) est appliquée sur la partie supérieure de la couche métallique.

7. Méthode selon la revendication 1, dans laquelle une couche supplémentaire (110) d'un matériau opto-électrique actif enserrée entre une première électrode supplémentaire (122) et une seconde électrode supplémentaire (132) est agencée, la première électrode supplémentaire étant appliquée sur la structure de couche électriquement isolante munie d'un motif munie de la couche métallique.

8. Méthode selon la revendication 7, dans laquelle à la fois la couche (10) de matériau opto-électrique actif et la couche supplémentaire (110) de matériau opto-électrique actif est une couche émettrice de lumière.

9. Méthode selon la revendication 7, dans laquelle la couche (10) de matériau opto-électrique actif est une couche émettrice de lumière et la couche supplémentaire (110) de matériau opto-électrique actif est une couche photovoltaïque.

10. Méthode selon la revendication 7, dans laquelle la couche (10) de matériau opto-électrique actif est une couche émettrice de lumière et la couche supplémentaire (110) de matériau opto-électrique actif est une couche électro chromique.

11. Dispositif opto-électrique comprenant :
- une couche (10) d'un matériau opto-électrique actif entre une première électrode (22) et une seconde électrode (32), dans laquelle, la première électrode (22) est formée par une première partie d'une couche électriquement conductrice (20) qui est appliquée au niveau d'un substrat (40), dans laquelle la couche électriquement conductrice comprend une seconde partie (24),
- une structure de couche électriquement isolante munie d'un motif (60) sur ladite seconde électrode (32), la structure de couche électriquement isolante munie d'un motif ayant des ouvertures (62)
- une structure métallique (80) sur la structure de couche électriquement isolante munie d'un motif (60) qui s'étend à travers les ouvertures (62) de la couche électriquement isolante munie d'un motif jusqu'à la seconde électrode (32), afin de venir en contact directement avec la seconde électrode (32),
dans lequel la seconde partie (24) de la couche électriquement conductrice (20) est électriquement isolée de la première partie (22), la seconde électrode (32) s'étendant sur cette seconde partie (24) de la couche électriquement conductrice (20), **caractérisé en ce que** la seconde électrode (32) est reliée électriquement à la seconde partie (24) de la couche électriquement conductrice (20).

12. Dispositif opto-électrique selon la revendication 11, comprenant un empilage ayant une couche supplémentaire (110) d'un matériau opto-électrique actif entre une troisième électrode (122) et une quatrième électrode (132), ledit empilage (110, 132, 122) étant agencé sur la structure de couche électriquement isolante munie d'un motif (60) munie de la structure métallique (80).

13. Dispositif opto-électrique selon la revendication 12, dans lequel à la fois la couche (10) d'un matériau opto-électrique actif et la couche supplémentaire (110) d'un matériau opto-électrique actif est une couche électro émettrice de lumière.

14. Dispositif opto-électrique selon la revendication 12, dans lequel la couche (10) de matériau opto-électrique actif est une couche émettrice de lumière et la couche supplémentaire (110) de matériau opto-électrique actif est une couche photovoltaïque.

15. Dispositif opto-électrique selon la revendication 12, dans lequel la couche (10) de matériau opto-électrique actif est une couche émettrice de lumière et la couche supplémentaire (110) de matériau opto-électrique actif est une couche électro chromique.
